# EUROPEAN PATENT SPECIFICATION

(11) **EP 3 729 923 B1**
(45) Date of publication and mention of the grant of the patent: **09.11.2022**
(21) Application number: 18810946.6
(22) Date of filing: 19.11.2018
(51) Int. Cl.: H05K 7/14, H05K 5/00

(54) **FASTENING A CARD IN AN INVERTER CARD GROUP**
BEFESTIGUNG EINER KARTE IN EINER WECHSELRICHTERKARTENGRUPPE
FIXATION D'UNE CARTE DANS UN GROUPE DE CARTES D'ONDULEUR

(30) Priority: 21.12.2017 TR 201721035
(43) Date of publication of application: 28.10.2020
(73) Proprietor: Arçelik Anonim Sirketi, 34445 Istanbul (TR)
(72) Inventor: GUNAYDIN, Metin, 34950 ISTANBUL (TR); BATUR, Yasin, 34950 ISTANBUL (TR)
(86) International application number: PCT/EP2018/081743
(87) International publication number: WO 2019/120813

(56) References cited:
- WO-A1-2008/153919
- US-A1- 2011 194 264

## Description

### TECHNICAL FIELD OF THE INVENTION

The present invention relates to structures enabling fastening and protecting an inverter electronic card provided in electronic household appliances.

### BACKGROUND OF THE INVENTION/PRIOR ART

Nowadays, structural fastening of different card groups in different electronic devices for practical usage is known. In known applications, such as in WO 2008/153919 A1 and US 2011/194264 A1, an electronic card is connected to the surface on which it is projected to be fastened, by being screwed, the card thus becomes structurally integral with the body of a holder. Screwing requires perforating the printed circuit board of the electronic card, thereby damaging it.

A patent publication of technical interest which may be referred to is JP 2007184206. Said patent relates to fitting an electronic card to a seat by associating it with the lower and the upper walls contained in the seat structure, and the adjacent portions, and making its connection to said walls and the adjacent portions by means of a special connection member. These connection members may be screws, as well as any seat joiner enabling the electronic card to be positioned firmly and in the correct position between the upper and the lower walls.

Another patent publication of technical interest which may be referred to is JP H06131514. This patent relates to a fastener designed also for an electronic card to address aims such as production facilitation. This housing formed by joining upper and lower walls, two side walls and a rear wall, all made of metal, is open on one side and comprises a space to contain a substrate therein. A spring, also made of metal, is defined between the upper and the lower surfaces.

On the other hand, some of the shortages in the known art about fastening electronic cards, are card fasteners and housings not being replaceable, and electronic cards being vulnerable.

In other terms, the system proposed according to the present invention, relates to improving the structures used in fastening electronic cards.

### OBJECTS OF THE INVENTION

The primary aim of the present invention is to eliminate the risk of structural damages occurring in the known art such as cracks on or breaking of the printed circuit card of an electronic card.

Another aim of the present invention is to enable a card to maintain its stability by means of a sufficient force applied by upper cover extensions to the center of the tabs, even when the tabs enabling keeping the card fixed break and fall off. The invention is defined in claim 1. Further embodiments are known from the dependent claims.

### BRIEF DESCRIPTION OF THE FIGURES

Presentative examples realized to achieve the aim of the present invention are illustrated in the accompanying drawings, and brief descriptions of these drawings are provided below.

In interpreting the protection scope of the invention, the technical drawings appended to the present specification shall not be used singly without consulting the specification. On the other hand, the appended technical drawings should be used not to determine and delimit but to interpret the protection scope of the present invention described in the claims. The invention is limited by the appended claims.

Unless otherwise specified, the appended figures do not designate the absolute dimensions of the product and the proportions of mutual parts do not exactly reflect the original product.
Figure 1: is a side view of the upper cover and the lower parts of the card fastener according to the present invention, with said parts assembled.
Figure 2: is a side view of the upper cover and the lower parts of the card fastener according to the present invention, with said parts ready to be assembled.
Figure 3: is a side view of the lower part of the card fastener provided according to the present invention.
Figure 4: is a view of the upper cover part of the card fastener provided according to the present invention, from above.
Figure 5: is a close up side view of the tab structure on the lower part of the card fastener provided according to the present invention, in a free state.
Figure 6: is a close up side view of the tab structure on the lower part of the card fastener provided according to the present invention, with the tabs interlocked to the upper cover extensions.
Figure 7: is a perspective view from above of the upper cover and the lower parts of the card fastener provided according to the present invention, with said parts interlocked.
Figure 8: is a close up perspective view from above of the tab structure on the lower part of the card fastener provided according to the present invention, with the tabs interlocked to the upper cover extensions.

### DETAILED DESCRIPTION OF THE INVENTION

The parts displayed in the figures incorporated to the specification for a better understanding of the invention, are individually numbered, and the description of each numbered part is given below.
1) Card fastener
2) Lower part
3) Electronic card
4) Fastening tab
5) Upper cover extension
6) Upper cover

The inverter card fastening system of the invention comprises a card fastener (1), and has a general arrangement in which a lower part (2), an electronic card (3) and an upper cover (6) join each other under proper conditions, forming integrity.

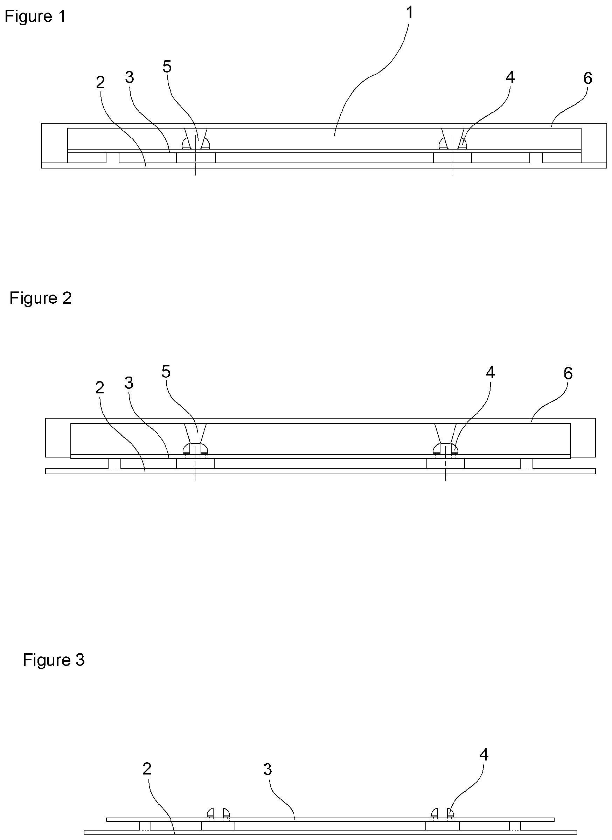

Figure 1 shows a side section of the card fastener (1) formed by mounting said lower part (2) and the upper cover (6). The upper cover extensions (5) which are part of said upper cover (6), fit into the space in the center of the fastening tabs (4) aligned immediately below the extensions (5), and enable the sharp corners of said fastening tabs (4) to constrain the electronic card (3) by bending the tabs on two sides due to their angled structure.

As can be seen in Figure 2, the upper cover part (6) of the card fastener is prepared for assembly by being positioned such that its edges overlap the borders of the lower part (2).

Figure 3 shows the lower part (2) of the card fastener (1) provided according to the present invention, the electronic card (3) placed thereon, and the fastening tabs (4) extending vertically by passing through the electronic card. The lower part (2) may be custom sized for an electronic card (3), thereby being produced so as to conveniently accommodate said electronic card (3). Said fastening tabs (4) are placed laterally symmetrically on the surface of the lower part (2), and extend on the vertical axis by passing through the holes bored accordingly on the electronic card (3).

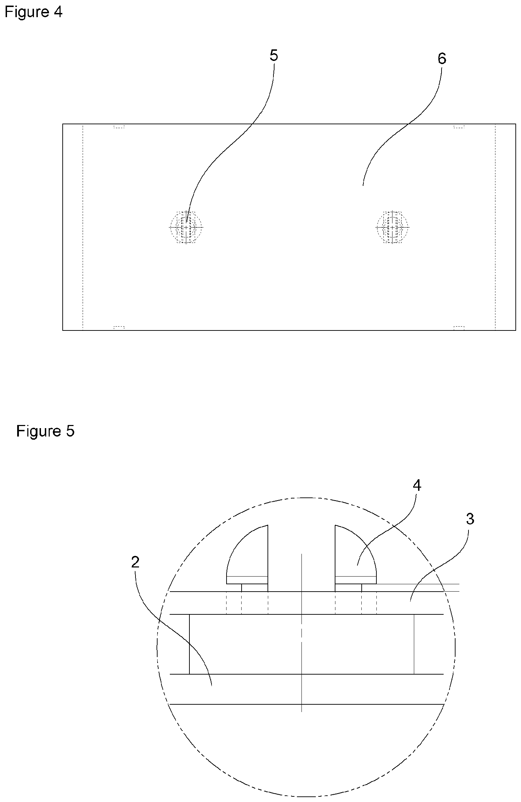

As can be seen in Figure 4, the upper cover part (6) of the card fastener is sized identically with the lower part (2), and comprises a pair of upper cover extensions (5) extending downwards in vertical axis, also positioned laterally symmetrically so as to completely interlock with both of the fastening tabs (4) connected to the lower part (2).

Figure 5 displays a close up view of the structure formed by the fastening tabs (4). In their free state, the fastening tabs (4) rest such that their flat portions face each other and their curved portions face opposite directions. In this state, a gap is defined in between for placement of the upper cover extensions (5) during assembly.

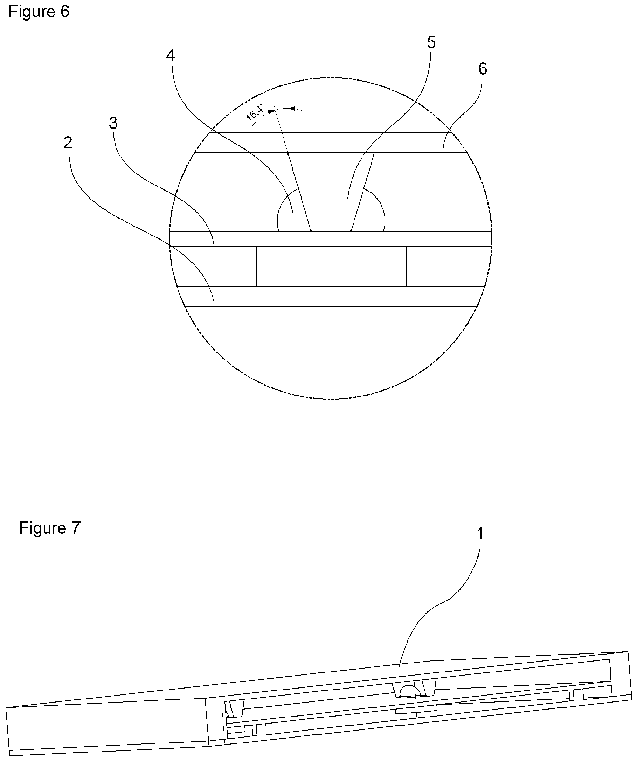

Figure 6 shows close up view of the state after completion of assembly by placement of the upper cover extensions (5) to the gap defined between the fastening tabs (4). Since the upper cover extensions (5) are designed so as to taper with an angle of 16.4 degrees with respect to the vertical axis, they enable the electronic card (3) to be constrained by the opening the fastening tabs (4) to both sides also with an angle of 16.4 degrees with respect to the vertical axis.

Figure 7 shows a perspective view from above of the state in which the lower part (2) and the upper cover (6) of the card fastener (1) are joined after assembly.

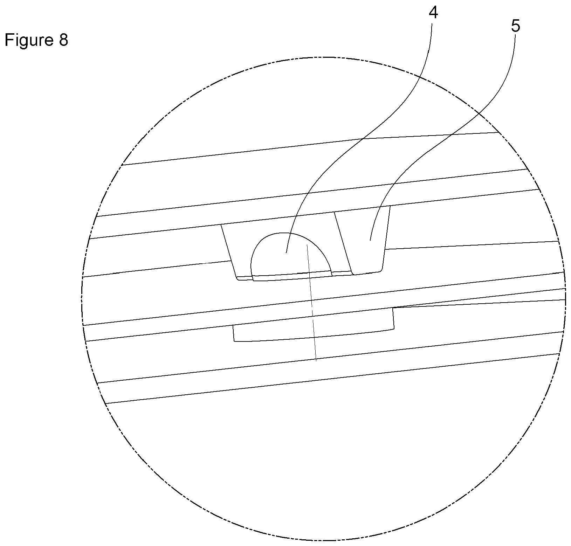

Figure 8 shows a perspective view from above of restraining the electronic card (3) by the upper cover extensions (5) opening the fastening tabs (4) to both sides and maximally contacting the card, as a consequence of the lower part (2) and the upper cover (6) being joined after assembly. Even if the fastening tabs break off due to a structural malfunction, the electronic card (3) does not become displaced and maintains its position thanks to this maximal contact and the dimensional compliance between the lower part (2) and the upper cover (6).

In an embodiment of the invention, a card fastener (1) is proposed gaining structural integrity by joining of a lower part (2) and an upper cover (6).

According to another embodiment of the invention, the card fastener (1) comprises two fastening tab (4) groups extending on vertical axis by passing through suitable slots of an electronic card (3) placed on said lower part (2).

According to another embodiment of the invention, said fastening tabs (4) groups are positioned symmetrically.

According to another embodiment of the invention, said upper cover (6) comprises upper cover extensions (5) positioned so as to align with the fastening tabs (4) on said lower part (2).

According to another embodiment of the invention, fastening of an electronic card (3) is enabled by the electronic card (3) being constrained by the fastening tabs (4) opening on both sides upon said upper cover (6) and the lower part (2) being joined.

According to another embodiment of the invention, said upper cover extensions (5) have a tapering structure having an angle with respect to vertical in the range of 14-18 degrees, preferably in the range of 15-17 degrees, and more preferably with an angle of 16.4 degrees.

According to another embodiment of the invention, said upper cover extensions (5) maintain a contact to the electronic card (3) sufficient to hold the electronic card (3) fixed in case of the fastening tabs (4) being broken off.

In conclusion, the main advantage provided by the present invention arises from comprising a means that eliminates the damages to an electronic card to be fastened induced by using known means such as screwing, in card fastening systems.

## Claims

1. A card fastener (1) comprising a lower part (2) and an upper cover (6), said lower part (2) and upper cover (6) being configured to form the card fastener (1) by being joined together, wherein said lower part (2) comprises two fastening tab (4) groups extending on vertical axis for passing through suitable slots of an electronic card (3) placed thereon, and said upper cover (6) comprises upper cover extensions (5) positioned so as to be aligned with the fastening tabs (4) on said lower part (2), **characterized in that** the fastening tabs (4) are configured to, upon said upper cover (6) and the lower part (2) being joined, open on both sides and fasten the electronic card (3) by constraining the electronic card (3).

2. A card fastener (1) according to claim 1, **characterized in that** said fastening tab (4) groups are positioned symmetrically.

3. A card fastener (1) according to claim 1 or 2, **characterized in that,** said upper cover extensions (5) have a structure tapering with an angle in the range of 14-18 degrees with respect to vertical axis.

4. A card fastener (1) according to claim 3, **characterized in that,** said upper cover extensions (5) have a structure tapering with an angle in the range of 15-17 degrees with respect to vertical axis.

5. A card fastener (1) according to claim 3 or 4, **characterized in that,** said upper cover extensions (5) have a structure tapering with an angle of 16.4 degrees with respect to vertical axis.

6. A card fastener (1) according to claim 1, **characterized in that,** said upper cover extensions (5) have a relative distance arrangement, maintaining a contact sufficient to hold the electronic card (3) fixed in case the fastening tabs (4) break off.

## Patentansprüche

1. Eine Kartenbefestigung (1) umfasst einen unteren Teil (2) und eine obere Abdeckung (6), wobei der untere Teil (2) und die obere Abdeckung (6) so konfiguriert sind, dass sie den Kartenverschluss (1) bilden, indem sie zusammengefügt werden, wobei der untere Teil (2) zwei Gruppen von Befestigungslaschen (4) umfasst, die sich auf einer vertikalen Achse erstrecken, um durch geeignete Schlitze einer darauf platzierten elektronischen Karte (3) hindurchzugehen, und die obere Abdeckung (6) obere Abdeckungsverlängerungen (5) umfasst, die so positioniert sind, dass sie mit den Befestigungslaschen (4) an dem unteren Teil (2) ausgerichtet sind, **gekennzeichnet ist sie durch** die Befestigungslaschen (4), die so konfiguriert sind, dass sie sich nach dem Verbinden der oberen Abdeckung (6) und des unteren Teils (2) auf beiden Seiten öffnen und die elektronische Karte (3) befestigen, indem sie die elektronische Karte (3) festhalten.

2. Eine Kartenbefestigung (1), wie in Anspruch 1 aufgeführt, ist **dadurch gekennzeichnet, dass** die Gruppen der Befestigungslaschen (4) symmetrisch angeordnet sind.

3. Eine Kartenbefestigung (1), wie in Anspruch 1 oder 2 aufgeführt, **ist dadurch gekennzeichnet, dass** die oberen Abdeckungsverlängerungen (5) eine Struktur haben, die sich mit einem Winkel im Bereich von 14 bis 18 Grad in Bezug auf die vertikale Achse verjüngt.

4. Eine Kartenbefestigung (1), wie in Anspruch 3 aufgeführt, **ist dadurch gekennzeichnet, dass** die oberen Abdeckungsverlängerungen (5) eine Struktur haben, die sich mit einem Winkel im Bereich von 15 bis 17 Grad in Bezug auf die vertikale Achse verjüngt.

5. Eine Kartenbefestigung (1), wie in Anspruch 3 oder 4 aufgeführt, **ist dadurch gekennzeichnet, dass** die oberen Abdeckungsverlängerungen (5) eine Struktur haben, die sich mit einem Winkel von 16,4 Grad in Bezug auf die vertikale Achse verjüngt.

6. Eine Kartenbefestigung (1), wie in Anspruch 1 aufgeführt, ist **dadurch gekennzeichnet, dass** die oberen Abdeckungsverlängerungen (5) eine relative Abstandsanordnung haben, die einen ausreichenden Kontakt aufrechterhält, um die elektronische Karte (3) fixiert zu halten, falls die Befestigungslaschen (4) abbrechen.

## Revendications

1. Un dispositif de fixation de carte (1) comprenant une partie inférieure (2) et un couvercle supérieur (6), ladite partie inférieure (2) et ledit couvercle supérieur (6) étant configurés pour former le dispositif de fixation de carte (1) en étant joints ensemble, dans lequel ladite partie inférieure (2) comprend deux groupes de pattes de fixation (4) s'étendant sur un axe vertical pour passer à travers des fentes appropriées d'une carte électronique (3) placée dessus, et ledit couvercle supérieur (6) comprend des extensions de couvercle supérieur (5) positionnées de manière à être alignées avec les languettes de fixation (4) sur ladite partie inférieure (2), **caractérisé en ce que** les languettes de fixation (4) sont configurées pour, lorsque ledit couvercle supérieur (6) et la partie inférieure (2) sont joints, s'ouvrir des deux côtés et fixer la carte électronique (3) en contraignant la carte électronique (3).

2. Un dispositif de fixation de carte (1) selon la déclaration 1, **caractérisé en ce que** lesdits groupes de pattes de fixation (4) sont positionnés symétriquement.

3. Un dispositif de fixation de carte (1) selon la déclaration 1 ou 2, **caractérisé en ce que** lesdites extensions du couvercle supérieur (5) ont une structure effilée avec un angle dans la gamme de 14-18 degrés par rapport à l'axe vertical.

4. Un dispositif de fixation de carte (1) selon la déclaration 3, **caractérisé en ce que** lesdites extensions du couvercle supérieur (5) ont une structure effilée avec un angle dans la gamme de 15-17 degrés par rapport à l'axe vertical.

5. Un dispositif de fixation de carte (1) selon la déclaration 3 ou 4, **caractérisé en ce que,** lesdites extensions du couvercle supérieur (5) ont une structure effilée avec un angle de 16,4 degrés par rapport à l'axe vertical.

6. Un dispositif de fixation de carte (1) selon la déclaration 1, **caractérisé en ce que,** lesdites extensions du couvercle supérieur (5) ont un arrangement de distance relative, maintenant un contact suffisant pour maintenir la carte électronique (3) fixée dans le cas où les languettes de fixation (4) se cassent.
